# EUROPEAN PATENT APPLICATION

(11) **EP 2 182 555 A1**
(43) Date of publication of application: **05.05.2010**
(21) Application number: 09252357.0
(22) Date of filing: 02.10.2009
(51) Int. Cl.: H01L 31/0352, H01L 31/18, B01J 2/28, C30B 11/00, B01J 2/00, C01B 33/02

(54) **Method for producing semiconductor particles**

(30) Priority: 06.10.2008 JP 2008259832; 26.12.2008 JP 2008332451
(71) Applicant: Clean Venture 21 Corporation, Kyoto-shi, Kyoto 601-8121 (JP)
(72) Inventor: Murozono, Mikio, Kyoto-shi, Kyoto 601-8121 (JP); Ohshima, Yoji, Kyoto-shi, Kyoto 601-8121 (JP); Nakamura, Toshiyuki, Kyoto-shi, Kyoto 601-8121 (JP); Akashi, Yoshihiro, Kyoto-shi, Kyoto 601-8121 (JP)
(74) Representative: Price, Paul Anthony King

(57) **Abstract**

A method for producing semiconductor particles includes the steps of forming granules of predetermined mass from a feedstock including a semiconductor powder by a granulation process; heating the granules to melt and fuse the semiconductor powder included in the granules, to obtain molten spheres; and cooling the molten spheres to solidify them, to obtain spherical semiconductor particles. The granules preferably contain a binder that binds the particles of the semiconductor powder together. When the granules contain a binder, it is preferable to perform a preliminary heating step for removing the binder from the granules before the heating step for melting the semiconductor powder.

## Description

### FIELD OF THE INVENTION

The invention relates to a method for producing spherical semiconductor elements such as spherical photovoltaic elements or semiconductor particles serving as the precursors thereof.

### BACKGROUND OF THE INVENTION

Recently, the use of a spherical semiconductor element as a photovoltaic element, a diode, a device for producing hydrogen by decomposing water, etc. has been examined. In particular, a photovoltaic element composed of a spherical p-type semiconductor particle and an n-type semiconductor layer formed on the surface of the p-type semiconductor particle has been receiving attention as an inexpensive element for a solar cell capable of providing high power. A representative device using such elements is a low concentrator-type spherical solar cell proposed, for example, in U.S. Pat. No. 6,706,959. This solar cell is composed of a support with a large number of recesses and spherical solar cell elements mounted in the recesses, and the inner faces of the recesses are utilized as reflecting mirrors. According to this proposal, since the thickness of the photovoltaic parts is reduced, the amount of expensive silicon can be reduced. Thus, the solar cell can be produced at a reduced cost Further, due to the light-collecting effect of the reflecting mirror, light that is 4 to 6 times as much as the light directly incident on the element is allowed to enter the element, and the light can be effectively utilized for photovoltaic conversion.

A method for producing semiconductor particles serving as the bodies of spherical semiconductor elements is a melt drop method, which is proposed, for example, in U.S. Pat. No. 4,188,177 and US 2006/0162763 A1. In this method, spherical semiconductor particles are produced by melting a semiconductor material in a crucible, continuously dropping it into a cooling tower from a nozzle at the bottom of the crucible under the pressure of an inert gas, and allowing the resulting droplets to solidify while dropping in the cooling tower.

According to the melt drop method, semiconductor particles of approximately 0.3 to 2 mm in diameter can be mass produced. However, the particles thus obtained are highly irregular in shape and mass. To use such highly irregular semiconductor particles as the bodies of spherical semiconductor elements, they need to be classifies into a predetermined particle diameter and formed into complete spheres by a process such as grinding.
As the semiconductor particles become more irregular in shape and size, the amount of particles discarded as a result of classification and the amount of scrap pieces produced from grinding increase, thereby leading to a significant loss of material and a low yield.

To solve these problems, more research is necessary with respect to facilities and production methods. There still remain various problems to be solved, such as optimization of the material and structure of the crucible, the size and shape of the nozzle, the pressure applied to the molten semiconductor, the atmosphere in the cooling tower, and the temperature of the atmosphere thereof. It is thus difficult, at present, to utilize the melt drop method in industrial application.

On the other hand, a powder melt method is proposed, for example, in U.S. Pat. No. 5,556,791, as an inexpensive method for producing spherical semiconductor particles capable of automating the production process. In this method, piles of semiconductor powder are melted by heating, and then solidified by cooling. More specifically, uniform mass piles of semiconductor powder, such as silicon, are spaced apart from one another. Optical energy is directed to the piles to melt the semiconductor powder of the piles, in order to convert the piles into molten spheres. These molten spheres are then solidified by cooling.

Such piles are formed, for example, in U.S. Pat. No. 5,431,127 in the following manner. First, a template having a plurality of holes of uniform shape in a predetermined pattern is placed on a refractory layer. A semiconductor powder is spread over the template, which is then brushed to fill the holes with the semiconductor powder. Thereafter, the template is lifted up, so that semiconductor powder piles of predetermined amount are formed on the refractory layer in the predetermined pattern. These piles are lumps or piles composed of a large number of semiconductor particles that merely gather together without being bound to one another.

The largest problem with this method is that the piles collapse when subjected to vibrations or impact in the process of forming the semiconductor powder piles, the process of storing the piles, and the process until heating the piles to melt the semiconductor powder. When the piles partially collapse, the masses of the piles become irregular. Also, when the piles collapse so that they are shaped like mountains that are wider at the bottom, the adjacent piles overlap where they collapse. When the piles in such a state are melted and solidified, the resulting semiconductor particles become highly irregular in mass, size, and shape, or the resulting semiconductor particles are often jointed together, thereby becoming defective.

Also, although a material doped with a dopant may be used as the semiconductor powder, an undoped material is usually used, because it is difficult to obtain a semiconductor powder that is uniformly doped under predetermined conditions, In such cases, after semiconductor particles are formed, they must be doped with a p-type or n-type dopant Hence, a series of steps for producing spherical semiconductor elements need an additional doping step, which also needs additional steps, facilities, and devices. As the doping method, for example, U.S. Pat No. 5,763,320 proposes a method of attaching a boron compound to the surface of a silicon particle, melting it by heating, and solidifying it

In the powder melt method, the object to be heated and melted is a semiconductor powder with a very small particle diameter. Such a semiconductor powder may be excessively oxidized in the process until it is heated to the melting temperature. If the semiconductor powder is excessively oxidized, the molten particles of the powder are not fused, and thus, molten spheres are unlikely to be formed. If the semiconductor powder is significantly oxidized, the amount of unoxidized semiconductor significantly decreases, and therefore, semiconductor particles of predetermined mass may not be obtained.

To solve these problems, U.S. Pat No. 5,556,791 and U.S. Pat No. 5,614,020 propose methods in which a high energy optical furnace is used to melt a semiconductor powder feedstock, and concentrated high intensity light is directed to a plurality of semiconductor powder piles to melt the piles. According to these methods, since focused high energy light is directed to the semiconductor powder piles, the semiconductor powder can be melted almost instantaneously, compared with methods using common furnaces. These methods can thus solve the problem of excessive oxidation of the semiconductor powder and molten spheres. However, these methods require subtle techniques in designing and operating the reverberatory furnace for focusing light on the piles transported into the furnace. Therefore, many problems remain unsolved with respect to the difficulty in producing the reverberatory furnace and the instability of the process.

### BRIEF SUMMARY OF THE INVENTION

There is therefore a need to address the above-described problems with the methods for producing semiconductor particles by the powder melt method and increase the productivity of semiconductor particles. The semiconductor particles produced by the invention are particularly effective as the bodies of spherical photovoltaic elements for use in photovoltaic devices to be installed in buildings such as houses for self-generation of electricity.

In one aspect of the invention, semiconductor particles are produced by forming granules of predetermined mass including a semiconductor powder, melting them, and solidifying them. The granules are formed from a feedstock including a semiconductor powder by a granulation process.

The invention relates to a method for producing semiconductor particles including the steps of:
(i) forming granules of predetermined mass from a feedstock including a semiconductor powder by a granulation process;
(ii) heating the granules to melt and fuse the semiconductor powder included in the granules, to obtain molten spheres; and

(i) cooling the molten spheres to solidify them, to obtain spherical semiconductor particles.

The semiconductor powder hardly separates from the granules formed by the granulation process in the respective steps from the granulation up to the heating step. As a result, it is possible to efficiently produce spherical semiconductor particles with small variation in mass, size, and shape.
While the novel features of the invention are set forth particularly in the appended claims, the invention, both as to organization and content, will be better understood and appreciated, along with other objects and features thereof, from the following detailed description taken in conjunction with the drawings. BRIEF DESCRIPTION OF THE SEVERAL VIEWS OF THE DRAWINGS

FIG 1 is a longitudinal sectional view of the main part of a tumbling granulator for producing granules in an embodiment of the invention;
FIG 2 is a plan view of the main part of a heating substrate on which the granules are aligned in an embodiment of the invention;
FIG 3 is a sectional view taken along line III-III of FIG 2;
FIG 4 is a longitudinal sectional view of an exemplary heat-treating furnace used in an embodiment of the invention;
FIG 5 is a plan view of a power generation unit of a photovoltaic device using spherical photovoltaic elements that are formed from silicon particles produced by the invention; and
FIG 6 is a longitudinal sectional view of the main part of the power generation unit illustrated in FIG 5.

### DETAILED DESCRIPTION OF THE EMBODIMENTS

In the method for producing semiconductor particles of the invention, granules of predetermined mass are formed from a feedstock including a semiconductor powder by a granulation process (step (i)), instead of the semiconductor powder piles in the powder melt method. The granules as used herein refer to small, solid or hard grains, but the granules may be soft or wet The granules are heated to melt and fuse the semiconductor powder in the granules for integration, to obtain molten spheres (step (ii)). The molten spheres are cooled and solidified, to obtain semiconductor particles (step (iii)).

In a preferable embodiment of the invention, the feedstock for forming the granules further contains a binder in addition to the semiconductor powder.

In this case, the particles of the semiconductor powder are fused together and trapped in the granules formed from the feedstock containing the binder. Thus, the semiconductor powder does not separate from the granules in the granulation step, the handling steps such as storage and transportation, and the heating step. As a result, it is possible to obtain spherical semiconductor particles having small variation in mass and good shape.
Also, defective semiconductor particles joined together are not produced, and the yield of the semiconductor powder is increased. It is therefore possible to significantly enhance the productivity of the semiconductor particles.

Generally, a binder is composed only of a polymer serving as the binder component, or contains a polymer and a solvent or a dispersion medium such as water or an organic solvent. The temperatures at which such binders vaporize by decomposition, combustion, evaporation, and the like are usually lower than the melting temperatures of semiconductor powders. Hence, in the step (ii), the binder is vaporized and removed from the granules.

In this preferable embodiment, the step (ii) preferably includes the steps of.
(ii-1) preliminarily heating the granules at a temperature that is equal to or higher than a temperature at which the binder vaporizes by thermal decomposition, combustion, or evaporation and is lower than a temperature at which the semiconductor powder melts; and
(ii-2) heating the preliminarily heated granules at a temperature equal to or higher than the temperature at which the semiconductor powder melts.

In this preferable embodiment, in the heating process before the semiconductor powder in the granules melts, the binder is vaporized and removed from the granules. This facilitates the fusing of the molten particles of the semiconductor powder and permits easy formation of molten spheres. Also, when the binder vaporizes rapidly by thermal decomposition, combustion, or evaporation, the granules may be damaged due to explosion. This problem can be solved by performing a preliminary heating step, i.e., the step (ii-1). As a result, semiconductor particles with small variation in mass, size, and shape can be obtained.

Further, in another preferable embodiment of the invention, the step (ii-1) includes a step of forcefully discharging ambient gas in order to remove the vaporized components produced by the heating of the granules from the atmosphere. If the vaporized components stay in the atmosphere, the vaporization of the binder is suppressed. The vaporized components include various substances, and are usually composed mainly of steam and carbon dioxide. Steam promotes the oxidation of the semiconductor powder, for example, silicon powder, and carbon dioxide gas interferes with the combustion of the binder. By forcefully discharging these vaporized components from the heating atmosphere, the vaporization of the binder is facilitated. Hence, the binder can be removed from the granules in a reliable manner, and the oxidation of the semiconductor powder can be suppressed. As a result, semiconductor particles having smaller variation in mass, size, and shape can be obtained.

It is preferable to use a binder that includes at least one polymer selected from the group consisting of polyvinyl alcohol, polyethylene glycol, hydroxypropyl cellulose, paraffin wax, carboxylmethyl cellulose, starch, and glucose as a binder component. The binder may be composed only of a binder component, or may be a liquid binder comprising a solution or dispersion of such a binder component as described above. Water or an organic solvent is used as the solvent or dispersion medium for the liquid binder. Further, when granules are produced by wet granulation, water itself can be used as the binder.

A particularly preferable binder is a powder, solution, or dispersion including at least one selected from the group consisting of polyvinyl alcohol, polyethylene glycol and paraffin wax, since it has good binding power and is readily available in high purity form.

Another aspect of the invention provides a method for producing spherical semiconductor particles containing a predetermined amount of a dopant at a low cost by adding a dopant source for making the conductivity type p-type or n-type to the above-described granules.
In this method, in the step (i), the feedstock for forming the granules further includes a dopant source for making the conductivity type of the semiconductor powder p-type or n-type in addition to the semiconductor powder. In the step (ii), the granules are heated to melt the semiconductor powder in the granules. As a result of this heat treatment, the dopant diffuses into the semiconductor powder and melts, so that molten spheres uniformly containing the dopant component are formed. In the step (iii), the molten spheres are cooled and solidified, to obtain spherical semiconductor particles. That is, the doping of the dopant can be effected in the process of producing the semiconductor particles, thereby making it possible to efficiently produce p-type or n-type spherical semiconductor particles with high quality.

The granules of the invention can be formed by various granulation processes. Generally, the process of forming grains from a powder, a dispersion of a powder in a liquid, or a powder wetted with a liquid is termed granulation. The grains produced by such a granulation process are the granules of the invention. One granule becomes one molten sphere when the semiconductor powder contained in the granule is fused in the heating step. Thus, the granules, which are the precursors of molten spheres, are not necessarily spherical, and may be of desired shape such as the shape of grains, pellets, flakes, or rectangular pieces.
Granulation processes are roughly classified into dry granulation and wet granulation. According to dry granulation, granules are usually formed without using a liquid binder or water by increasing the cohesive force of a material, and a representative method is compression granulation. Examples of compression granulation include: a method of loading a predetermined amount of a powder into a cylinder, and compressing the powder between the upper and lower pistons of a press; and a method of compressing a powder between two rotating rolls. Dry granulation does not need a drying step.

According to wet granulation, granules are usually formed by utilizing the adhesive power of water or a binder component. Water can act as a binder when used alone. In such cases, water is regarded as a binder for convenience sake. Representative methods of wet granulation include tumbling granulation, fluidized bed granulation, agitation granulation, and spray granulation. According to tumbling granulation, granules are formed, for example, by rolling a semiconductor powder in a cylindrical container whose bottom rotates while adding a suitable amount of a liquid binder, in order to form solid nuclei comprising a mixture of the semiconductor powder and the liquid binder, and causing the solid nuclei to grow into granules.

According to fluidized bed granulation, granules are formed, for example, by forming a powder fluidized bed in a space in a container to which hot air is supplied from below the container, and spraying a liquid binder thereon from above the fluidized bed or from the wall of the container. According to agitation granulation, granules are formed, for example, by mixing and agitating a semiconductor powder and a liquid binder due to the rotation of a biaxial screw. In another wet granulation method, a slurry comprising a semiconductor powder dispersed in a liquid binder is dropped from a nozzle to form droplets shaped like particles while dropping, and the droplets are solidified. Examples of solidification methods include a method of dropping the droplets into a liquid that does not dissolve the slurry, collecting them, and drying them.

The granules of the invention can be produced by various granulation processes in addition to the above-described methods. For example, in a preferable method, a feedstock for forming granules is formed into a sheet or noodle shape, which is then cut to a predetermined size. Specifically, first, a semiconductor powder or a mixture containing a semiconductor powder and other materials such as a binder is prepared. The semiconductor powder or mixture may be formed into small grains by a suitable granulation process, if necessary. Subsequently, the semiconductor powder, mixture, or small grains are compressed between two rotary rollers or pressed by a press, so that they are formed into a sheet with a predetermined thickness or a noodle with a predetermined cross-sectional area. The sheet or noodle is cut to predetermined dimensions and shape such as a rectangular or pellet shape, to obtain granules of predetermined mass.

In wet granulation, a solution or dispersion of a polymer in water or an organic solvent is commonly used as the liquid binder. In dry granulation, a powdered polymer can be used as the binder.

The semiconductor powder used as a raw material of the semiconductor particles of the invention preferably has a mean particle diameter of 10 to 100 µm. Selecting a mean particle diameter of the semiconductor powder from this range permits the formation of granules with small variation in the mass of the semiconductor powder. Further, in the step (ii) of heating and melting the granules, all the semiconductor powder can be melted without leaving any unmelted portion.

In the step (ii), the granules formed in the above manner are heated to melt and fuse the semiconductor powder in the granules, to obtain molten spheres. In this case, in order to efficiently heat-treat a large number of granules at one time, it is preferable to dispose these granules such that they are spaced apart from one another.

Hereinafter, a description is made of embodiments in which the invention is applied to the production of silicon particles. However, the invention is applicable to the production of particles of semiconductors such as germanium and gallium-arsenic as well as silicon particles.

### EMBODIMENT 1

This embodiment describes the step (ii) in the case where the feedstock for forming granules contains a binder.
When a silicon powder is used as a semiconductor powder, the heating temperature for melting the semiconductor powder in the granules in the step (ii) needs to be equal to or higher than the melting temperature (1413°C) of silicon. If the heating temperature in the step (ii) is too high, the heating furnace deteriorates within a short period of time. Thus, the upper limit temperature can be determined in consideration of the necessary heat resistance, durability, and cost efficiency such as costs necessary for heating. In industrial application, the heating temperature is 1500°C or lower, and preferably 1460°C or lower.

For the production of silicon particles, it is preferable to heat the granules in the step (ii-1) in a temperature range between 500°C at which the binder vaporizes and 1412°C at which the silicon powder in the granules remains unmelted, and to heat the granules in the step (ii-2) at 1413 to 1500°C, desirably 1413 to 1460°C, to melt and fuse the silicon powder.

Preferable binder components in the invention include polyvinyl alcohol, polyethylene glycol, and paraffin wax. When they are heated to 400 to 500°C, they vaporize by evaporation, thermal decomposition, or combustion. Also, water or an organic solvent such as methanol or ethanol used as a solvent or dispersion medium for a liquid binder vaporizes when heated to 400 to 500°C. Hence, by setting the heating temperature in the step (ii-1) to 500°C or higher, substantially all the binder is vaporized and removed from the granules.

Also, the semiconductor in the granules is in powder form and thus easily oxidized, If the oxygen concentration in the atmosphere in the step (ii-1) is high, an oxide film tends to be formed on the surface of the semiconductor power. If such an oxide film is excessively formed, it may interfere with the fusing of the molten semiconductor powder in the step (ii-2). If the semiconductor powder is significantly oxidized, the majority of the semiconductor powder is consumed as an oxide before being melted, and semiconductor particles of desired quality may not be produced.

In the step (ii-2), it is preferable to melt and fuse the semiconductor powder in the granules, and to form a suitable oxide film on the surface of the molten granules, since the suitable oxide film is necessary for allowing the molten granules to keep a spherical shape. In this case, it is preferable to use a suitable oxidizing atmosphere as the atmosphere in which the heat treatment is performed. If the oxygen concentration in the atmosphere is too low, a sufficient oxide film to allow the molten granules to keep a spherical shape is not formed, and thus the molten granules spread over the heating substrate, wetting the surface of the substrate. Even if they are solidified, spherical particles cannot be obtained. Also, if the oxygen concentration in the atmosphere is too high, the molten semiconductor is oxidized excessively. Even if it is solidified, semiconductor particles cannot be obtained, or the resultant particles are covered with a thick oxide film. In order to use such particles in a semiconductor device, it is necessary to remove the thick oxide film by a process such as grinding, which results in a large material loss. Also, the yield of spherical semiconductor particles with predetermined characteristics decreases significantly.

For the reasons as described above, it is preferable to preliminarily heat the granules in the step (ii-1) in an inert gas or a substantially inert atmosphere composed mainly of an inert gas, and to heat the granules in the step (i-2) in an atmosphere having a higher oxygen concentration than the inert atmosphere in the step (ii-1). More preferably, the oxygen concentration in the atmosphere in the step (ii-1) is less than 1% by volume, and the oxygen concentration in the atmosphere in the step (ii-2) is 5 to 20% by volume.

If the oxygen concentration in the atmosphere in the step (ii-1) is low, the polymer thermally decomposes at a slightly high temperature, and a combustion reaction is unlikely to occur. For example, when the binder component is polyvinyl alcohol, water and carbon dioxide gas of the vaporized components decrease, and lower hydrocarbons such as methane and ethane and other components such as acetone and aldehyde vaporize. Therefore, in the step (ii-1), it is preferable to set the temperature for heating the granules in the substantially inert atmosphere to a slightly higher temperature than the temperature for heating the granules in an atmosphere with a high oxygen concentration. However, in practice, regardless of the oxygen concentration in the atmosphere, if the heating temperature is set to 500°C or higher, substantially all the binder is vaporized and removed from the granules.

### EMBODIMENT 2

This embodiment describes an example in which the feedstock for forming granules contains a dopant source.
In another preferable embodiment of the invention, in the step (i), granules are formed from the feedstock including a semiconductor powder of predetermined mass and a dopant source for making the conductivity type of the semiconductor powder p-type or n-type. In the step (ii), the granules are heated to melt and fuse the semiconductor powder contained therein, to obtain molten spheres including the dopant. In the step (iii), the molten spheres are cooled and solidified. In this way, p-type or n-type semiconductor particles can be produced.

By using the granules containing the semiconductor powder, dopant source, and further, a binder, the semiconductor powder and the dopant source do not separate from the granules in the respective steps from the granulation up to the heat treatment It is thus possible to efficiently produce spherical semiconductor particles having a significantly reduced variation in mass, size, and shape and being uniformly doped with a predetermined amount of an n-type or p-type dopant.

In the step (i), granules may be formed without using a binder by a method such as compression molding, but it is common to use a binder for producing granules. It is preferable to produce granules containing a dopant source by the following methods.

In a first method, a mixture including a semiconductor powder, a dopant source, and preferably a binder is prepared, and the mixture is formed into granules by a granulation process. It is preferable to prepare the mixture by kneading a liquid binder with a dopant source added thereto and a semiconductor powder. As another method, it is also possible to add a dopant source powder to a semiconductor powder and mixing the powders. The powders can be mixed by using a common powder mixer. When the amount of the dopant source powder added to the silicon powder is very small, the homogeneity of the powder mixture can be enhanced by intermittently spraying compressed air into the powder mixture to fluidize the powders. Alternatively, by fluidizing a silicon powder and spraying a dopant source powder thereon from a nozzle, a homogeneous mixture can be obtained.

In a second method, first, a semiconductor powder is brought into contact with a solution of a dopant source to attach the dopant source to the surface of the semiconductor powder. The semiconductor powder with the dopant source attached thereto and, if necessary, other materials such as a binder are formed into granules. In order to bring the surface of the semiconductor powder into contact with the dopant source solution, the semiconductor powder is mixed or wetted with the dopant source solution, or the semiconductor powder is immersed in the dopant source solution. By drying the semiconductor powder, the dopant source can be attached to the surface of the semiconductor powder in a more reliable manner.

In a third method, in the process of forming granules by a granulation process, raw materials including a dopant source are mixed to form granules. The granules thus obtained are dried, if necessary. In this case, it is preferable that the raw materials include a liquid binder with a dopant source added thereto.

In a fourth method, first, granules containing a semiconductor powder and preferably a binder are formed by a granulation process, and the granules are brought into contact with a dopant source solution. For example, the granules are immersed in the dopant source solution for a predetermined time, taken out, and dried. Alternatively, the granules may be wetted with a dopant source solution, for example, by spraying the dopant source solution thereon, and if necessary, dried.
Boric add is usually used as a p-type dopant source, but boron oxide or the like may be used. Also, phosphorus, a phosphorus compound, triphenylphosphine oxide, or the like can be used as an n-type dopant source.

### EXAMPLES

Representative examples of the method for producing semiconductor particles according to the invention are hereinafter described step by step. These examples produce silicon particles and are to be construed as not limiting in any way the invention.

### Stew

In this step, a large number of granules of predetermined mass are formed from a feedstock containing a semiconductor powder by a granulation process. The feedstock for forming granules is either composed only of a semiconductor powder, or composed of a semiconductor powder and materials such as a binder and/or a dopant source. In this example, the latter feedstock is used to form granules.

It is preferable to use a silicon powder of semiconductor grade, but the silicon powder may be of metallurgical grade. In this example, using a non-doped silicon powder of semiconductor grade, granules comprising the silicon powder and a binder are formed by tumbling granulation, and the granules are dried, if necessary.

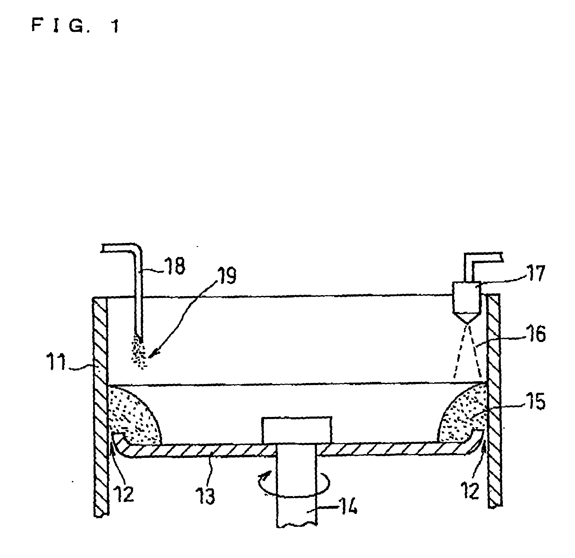

The formation of granules serving as the precursors of silicon spheres of approximately 1 mm in diameter is hereinafter described. FIG. 1 is a longitudinal sectional view of the main part of a tumbling granulator during operation. The granulator includes a cylindrical flame 11, a disc (bottom plate) 13 disposed in the cylindrical flame 11, and an air slit 12 between the cylindrical flame 11 and the disc 13. The disc 13 is approximately 40 cm in diameter and supported by a supporting bar 14 rotatably.

Approximately 3000 g of a silicon powder 15 is introduced into the disc 13. Subsequently, the disc 13 is rotated at a speed of 100 to 300 rpm to move and roll the silicon powder 15 between the outer periphery of the disc 13 and the inner wall of the flame 11. Approximately 750 cc of a liquid binder 16 is sprayed toward the silicon powder 15 from a spray gun 17 at a uniform speed for 30 to 60 minutes. The rotation of the disc 13 may be continued for 15 to 30 minutes after the completion of spraying of the liquid binder 16. In the liquid binder 16, 10 parts by mass of polyvinyl alcohol serving as the binder component is dissolved in 100 parts by mass of water.

By the above operation, the silicon powder 15 and the liquid binder 16 are homogeneously mixed and formed into granules while rolling. During the operation, air is supplied from the air slit 12, which prevents part of the silicon powder 15 and the binder 16 from falling from the air slit 12 while promoting the rolling of the silicon powder 15.

The granules are sieved to obtain granules of predetermined mass range and granules of smaller mass. The granules of predetermined mass range are used in the next step. The granules of smaller mass than the predetermined mass range (small grains) can be made larger by using the granulator of FIG 1, to obtain granules of the predetermined mass range.

Small grains can be made larger in the following manner. First, small grains are fed to the disc 13 in FIG 1, and the disc 13 is rotated to move and roll the small grains (corresponding to the silicon powder 15 in FIG. 1) between the outer periphery of the disc 13 and the inner wall of the flame 11. While spraying the liquid binder 16 on the rolling small grains from the spray gun 17, additional silicon powder 19 is sprayed from a nozzle 18 of a powder sprayer (not shown). The rotation of the disc 13 is continued for some time.

By the above operation, new silicon powder is attached to the surface of the small grains by the binder, so that the small grains become larger. The resultant grains are sieved to obtain granules of predetermined mass range. The amount of the additional silicon powder 19 to be sprayed is determined depending on the particle diameter distribution of the small grains and the like. By repeating the above operation of making the particle diameter larger, if necessary, the silicon powder of the feedstock can be utilized more effectively

The mass of the granules obtained by granulation can be suitably adjusted by changing the amount and particle diameter of the silicon powder introduced, the composition and amount of the binder used, the operating conditions of the granulator, etc. When the mean particle diameter of the silicon powder is 10 to 100 µm, granules of relatively uniform mass can be obtained. Also, spherical photovoltaic elements or silicon particles serving as the precursors thereof are usually 0.5 to 2.0 mm in diameter, and their mass is approximately 0.15 to 9.8 mg. For the production of such elements, the mass of the granules is set to approximately 0.16 to 10.1 mg. In this example, granules of approximately 1.26 mg are formed to produce silicon particles of approximately 1.0 mm in diameter for a solar cell.

In order to increase the strength of the granules and facilitate handling, it is preferable to dry and remove the moisture in the binder contained in the granules where appropriate. In this case, during the transport to the next step and the heat treatment in the next step, the separation of the silicon powder from the granules is further suppressed. It is thus possible to obtain silicon particles having small variation in mass and being free from defective particles jointed together.

When granules are formed in the above manner using a liquid binder that is prepared by further dissolving 1.6×10⁻³ part by mass of boric add in the above-mentioned liquid binder in which 10 parts by mass of polyvinyl alcohol is dissolved in 100 parts by mass of water, granules uniformly containing a predetermined amount of a dopant can be obtained.

Various liquid binders can be used as the binder. Among them, the use of an aqueous solution containing polyvinyl alcohol or polyethylene glycol as the binder component can provide substantially spherical granules having relatively good uniformity of mass and adhesion among the silicon powder particles. For example, with respect to the composition of the liquid binder, it is preferable to use 5 to 20 parts by mass of polyvinyl alcohol or polyethylene glycol per 100 parts by mass of water. Further, with regard to the contents of the silicon powder and binder component in the granules, it is preferable to use 2 to 5 parts by mass of the binder component per 100 parts by mass of the silicon powder. Further, when the granules contain a dopant source, it is preferable to use, for example, 1×10⁻⁴ to 1×10⁻³ part by mass of boric acid per 100 parts by mass of the silicon powder.

### Step (ii)

In this step, the granules formed in the step (i) are heated at a temperature equal to or higher than the melting point of the semiconductor powder in the granules to melt and fuse the semiconductor powder, to obtain molten spheres. The granules formed in the step (i) are either granules composed only of the semiconductor powder or granules composed of the semiconductor powder and other materials such as a binder and/or a dopant source.
This step has the following two embodiments:
(a) an embodiment in which the step of heating the granules (heat treatment) comprises only the step of heating the granules at a temperature equal to or higher than the melting temperature of the semiconductor powder, and
(b) an embodiment in which the step of heating the granules (heat treatment) includes the step of preliminarily heating the granules at a temperature lower than the melting temperature of the semiconductor powder prior to the step of heating the granules at a temperature equal to or higher than the melting temperature of the semiconductor powder.
   It is effective to apply the embodiment (b) to cases where the granules contain a binder.

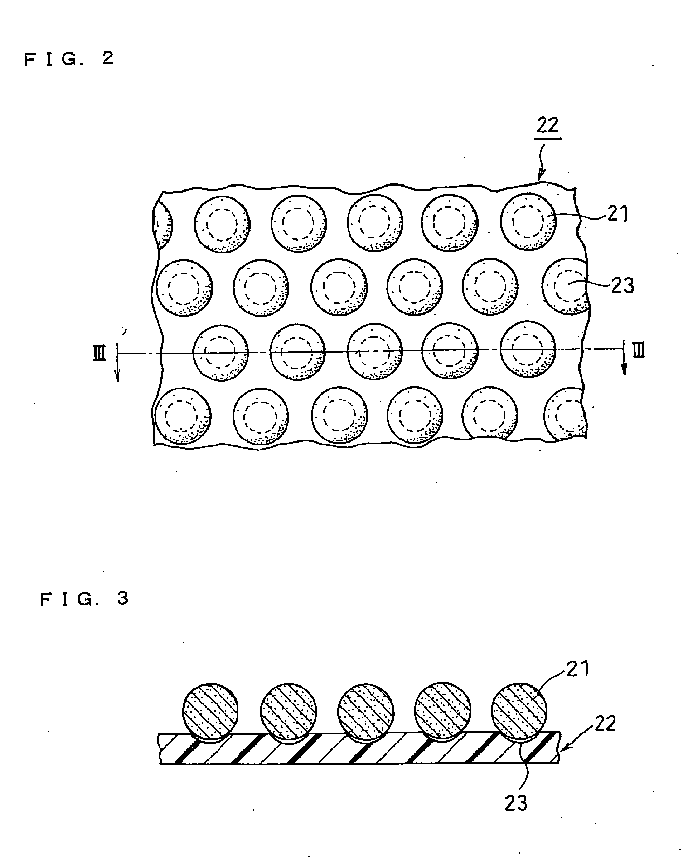

First, the embodiment (a) is described. FIG 2 is a plan view of the main part of a heating substrate on which the granules are disposed. FIG. 3 is a cross-sectional view taken along line III-III in FIG. 2.

A heating substrate 22 is made of quartz glass and has a thickness of 0.5 mm, a width of 300 mm, and a length of 300 mm. The heating substrate 22 has a large number of recesses 23 in a regular pattern, and the opening of each recess 23 has a diameter of approximately 0.5 mm. Each recess 23 receives the bottom of each granule 21 having a mass of approximately 1.26 mg produced in the step (i). For example, approximately 20,000 granules 21 are disposed on the heating substrate 22 at a high density such that they are spaced apart from one another. For the material of the heating substrate, it is necessary to select a material having low reactivity with silicon and high heat resistance. Besides quartz glass, for example, aluminum oxide or silicon carbide coated with silicon nitride can be used. In FIGs. 2 and 3, the granules 21 are illustrated as having a completely spherical shape, but do not need to have a completely spherical shape. As explained previously, the granules can have various shapes in addition to a spherical shape.

Next, the substrate 22 with the granules 21 illustrated in FIG 2 is introduced into a heating furnace. The substrate 22 is heated to approximately 1450°C within approximately 10 minutes, and this temperature is maintained for approximately 10 minutes. As a result, the binder is vaporized and removed from the granules 21, so that a molten semiconductor free from the binder and residues thereof is formed. When this heat treatment is applied to granules containing boric acid as the dopant source, first, the boric acid in the granules decomposes and boron diffuses on the silicon powder surface. Then, the silicon powder melts, so that molten silicon spheres doped with a predetermined concentration of boron are formed.

An atmosphere furnace for baking ceramics and the like is used as the heating furnace, and induction heating or resistance heating heaters are used as the heat source therefor. The heating furnace has exhaust holes for discharging the vaporized components produced by heating from the furnace. The heating method as described above can also be used even when granules produced without using a binder are used to form molten spheres. In this case, the exhaust holes are not indispensable.

I n order to allow the molten silicon to keep a spherical shape, it is preferable to form a silicon oxide on the surface of the molten silicon. It is thus preferable that the atmosphere in the furnace contain a suitable amount of oxygen. While the atmosphere may be air, the air in the furnace may be partially replaced with an inert gas to prevent excessive oxidation of the silicon powder or molten silicon. In this case, the oxygen concentration is preferably 5 to 20% by volume. While the inert gas may be argon, helium, or the like, it is usually argon in terms of the cost and the like. The heating temperature for melting the silicon powder is 1413°C or higher, and is preferably 1500°C or lower, and more preferably 1460°C or lower, in order to allow the molten silicon to keep a spherical shape and suppress softening and wear of the substrate or wear of the furnace material and the heat source.

Next, the embodiment (b) is specifically described. The embodiment (b) has the steps of:
(ii-1) preliminarily heating the granules containing a binder at a temperature that is equal to or higher than the temperature at which the binder vaporizes and is lower than the temperature at which the semiconductor powder melts; and
(ii-2) heating the granules at a temperature equal to or higher than the temperature at which the semiconductor powder melts, to obtain molten spheres.
In the step (ii-1), it is preferable to forcefully discharge ambient gas. For the production of silicon particles, it is preferable to set the heating temperature in the step (ii-1) to 500 to 1412°C, and to set the heating temperature in the step (ii-2) to 1413 to 1500°C.

An example of forming molten silicon spheres is hereinafter described in details.

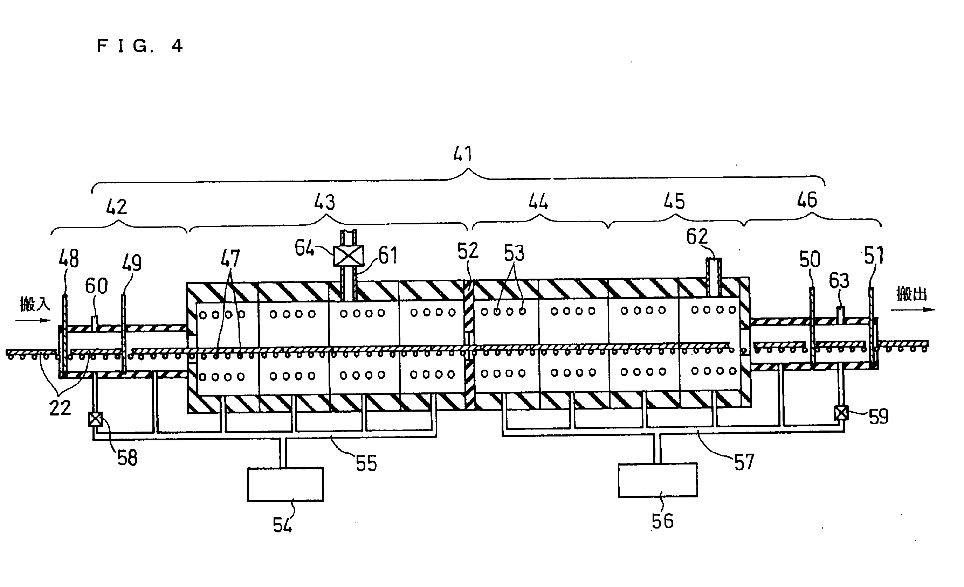

FIG 4 illustrates a representative heat-treating furnace 41 for heat-treating granules. For example, the heating substrates 22 of FIGS. 2 and 3 with the granules 21 disposed thereon are prepared, and these granules 21 are heat treated in the heat-treating furnace 41. The heat-treating furnace 41 is a ceramics furnace whose inner wall has good resistance to heat and corrosion. The heat-treating furnace 41 is set such that it has a predetermined atmosphere therein and a predetermined temperature profile. The substrates 22 with the granules 21 thereon are successively introduced into the heat-treating furnace 41 to melt and fuse the silicon powder contained in the granules 21, to obtain molten spherical granules, which are then cooled, solidified, and taken out as spherical silicon particles.

The heat-treating furnace 41 is composed of an entrance section 42, a preliminary heating section 43, a melt section 44, a solidification section 45, and an exit section 46. A roller conveyor 47 is disposed through these sections. The entrance section 42 has shutters 48 and 49, while the exit section 46 has shutters 50 and 51. By opening and dosing these shutters, the atmosphere in the preliminary heating section 43, the melt section 44, and the solidification section 45 is maintained in a predetermined state, and the heating substrates 22 are introduced into the heat-treating furnace 41 from the entrance section 42 and carried out of the exit section 46. In this way, the granules disposed on the substrate 22 can be subjected to a predetermined heat-treatment.

Between the preliminary heating section 43 and the melt section 44 is a partition 52 having an opening that is large enough for the heating substrates 22 to pass through. The partition 52 can prevent the substantially inert atmosphere in the preliminary heating section 43 and the oxidizing atmosphere in the melt section 44 from mixing together. Further, the preliminary heating section 43 and the melt section 44 are equipped with a plurality of heaters 53 therein. As is often the case, the temperatures in the respective sections in the furnace are detected by ptatinum-ptatinum rhodium alloy temperature sensors and the like disposed therein, and the current supplied to the heaters 53 is controlled so that the temperature distribution in the furnace has a predetermined profile. Instead of the heat-treating furnace utilizing such electric heaters, it is also possible to use a microwave heat-treating furnace.

The entrance section 42 and the preliminary heating section 43 of the heat-treating furnace 41 are connected with a gas supply pipe 55 for supplying an inert gas from an inert gas supply unit 54. Also, the melt section 44, the solidification section 45, and the exit section 46 are connected with a supply pipe 57 for supplying, when necessary, a low oxidizing gas comprising a mixture of an inert gas and oxygen from a low oxidizing gas supply unit 56. The gas supply pipe 55 connected to the entrance section 42 has a branch pipe equipped with a valve 58, and the gas supply pipe 57 connected to the exit section 46 has a branch pipe equipped with a valve 59. The operation of opening and dosing these valves 58 and 59 is done in synchronization with the opening and dosing of the shutters 48 and 49 and the shutters 50 and 51. Exhaust pipes 60,61,62, and 63 are provided between the shutters 48 and 49 of the entrance section 42, at the center of the preliminary heating section 43 in the transport direction, at the end of the solidification section 45 in the transport direction, and between the shutters 50 and 51 of the exit section 46, respectively. The exhaust pipe 61 is connected to an exhaust fan (not shown) via a valve 64.

The inert gas supplied from the inert gas supply unit 54 is preferably high purity argon. However, it is also possible to use an inert gas for industrial use, because it can realize a substantially inert atmosphere if the oxygen concentration does not exceed 1% by volume. The low oxidizing gas supplied from the low oxidizing gas supply unit 56 preferably has an oxygen concentration of 5 to 20% by volume.
In the embodiment (b), the heat treatment is performed by using the heat-treating furnace 41, for example, by the following manner. It should be noted that although the atmosphere in each of the preliminary heating section 43 and the melt section 44 may be air, the following describes a preferable embodiment in which the preliminary heating section 43 has a substantially inert atmosphere and the melt section 44 has an oxidizing atmosphere having a higher oxygen concentration than the atmosphere in the preliminary heating section.

First, with the valves 58, 59, and 64 and the inner shutters 49 and 50 dosed, an inert gas is supplied to a part of the entrance section 42 and the preliminary heating section 43 from the inert gas supply unit 54 through the supply pipe 55. As a result the air in the major parts of the furnace is discharged from the exhaust pipe 62 through the opening of the partition 52, the melt section 44, and the solidification section 45, so that most of the air in the heat-treating furnace 41 is replaced with the inert gas. Thereafter, a low oxidizing gas is supplied to the melt section 44, the solidification section 45, and a part of the exit section 46 from the low oxidizing gas supply unit 56 through the supply pipe 57, so that the atmosphere therein is replaced with the low oxidizing gas. At this time, the atmosphere in the melt section 44 has a slightly lower pressure than the preliminary heating section 43 into which the inert gas flows. This prevents the low oxidizing gas on the melt section 44 side from entering the preliminary heating section 43 through the partition 52.

After the atmosphere inside the heat-treating furnace 41 is adjusted, the shutter 48 of the entrance section 42 is opened, and the substrate 22 with the granules disposed thereon is introduced between the shutters 48 and 49 of the entrance section 42 by the roller conveyor 47. Then, with the shutter 48 dosed and the valve 58 opened, the inert gas is introduced. As a result, the air therein is discharged from the exhaust pipe 60 and replaced with the inert gas. The shutter 49 is then opened, and the substrate 22 is transported toward the preliminary heating section 43. After the completion of transport of the first substrate 22, the shutter 49 is dosed, and the valve 58 is dosed to stop the supply of the inert gas. The shutter 48 is then opened, and the next substrate 22 is introduced between the shutters 48 and 49. After the introduction of the next substrate 22, the air in the entrance section 42 is replaced with the inert gas in the same manner as described above. After the completion of the replacement, the substrate 22 is transported toward the preliminary heating section 43. In the same manner, the substrates 22 with the granules disposed thereon are sequentially introduced into the heat-treating furnace 41.

The temperature inside the preliminary heating section 43 of the heat-treating furnace 41 is set such that it becomes higher from the entrance section 42 side toward the partition 52. The temperature is maintained at 500 to 600°C near the entrance of the preliminary heating section 43 and at 1350 to 1412°C near the partition 52. In the preliminary heating section 43, the granules are heated while being transported therein, so that the binder contained in the granules is decomposed or vaporized. As a result, almost all the binder is removed from the granules. During the preliminary heating, the valve 64 is opened, so the vaporized components of the binder as well as the inert gas in the preliminary heating section 43 are forcefully discharged from the furnace through the exhaust pipe 61. Therefore, the atmosphere in the preliminary heating section 43 is kept substantially inert and dear.

The granules, from which the binder has been removed, pass through the partition 52 and enter the melt section 44, which has an oxidizing atmosphere heated to approximately 1450°C. In this atmosphere, the silicon powder of the granules melts to form molten spheres. At this time, the granules are heated for a sufficient period of time for all the silicon powder in each granule to melt and form a molten sphere. During this period of time, a thin oxide film is formed on the surface of each molten granule, thereby allowing the molten granules to have and keep a spherical shape.

In the case of the granules containing boric add as the dopant source, when the granules are heated in the preliminary heating section 43 while being transported therein, the binder contained in the granules is vaporized, the boric acid is decomposed, and boron diffuses into the silicon powder. The granules then pass through the partition 52 and enter the melt section 44 having a low oxidizing atmosphere heated to approximately 1450°C. When carbon and other residues of the binder vaporized in the preliminary heating step adhere to the granules, these components are oxidized, vaporized, and substantially disappear in the melt section 44. At the same time, the silicon powder in the granules melts, and the molten silicon powder particles fuse together to form molten spheres evenly doped with boron.

### Step (iii)

In this step, the molten spheres formed in the step (ii) are cooled and solidified to produce semiconductor particles. When the granules contain a dopant source, semiconductor particles doped with a dopant determining the conductivity thereof can be produced. The mass and diameter of the semiconductor particles obtained in this step are almost determined by the mass of the granules serving as the precursors thereof.

When the molten silicon spheres obtained in the step (ii) are rapidly cooled, the molten semiconductor is trapped in the outer solidified shells of the silicon spheres, and as they are further cooled, the inner semiconductor solidifies. Upon the solidification, the volume of the inner semiconductor increases, and thus, stress builds up in the semiconductor particles. The stress may cause the outer shells of the particles to break, thereby forming abnormal protrusions, or may cause the particles to become cracked. For these reasons, it is preferable to set the cooling speed to such a suitably slow speed that the productivity is not impaired.

When the granules having a mass of approximately 1.26 mg formed in the step (i) are heat-treated in the step (ii) to obtain molten silicon, and the molten silicon is cooled and solidified in the step (iii), spherical silicon particles with a particle diameter of approximately 1.0 mm and a mass of approximately 1.22 mg can be obtained. In this case, for example, the temperature in the heating furnace is lowered from 1450°C to 1370°C in 5 minutes to solidify the molten silicon, which is then allowed to cool naturally in the heating furnace to obtain silicon particles.

The molten silicon obtained in the melt section 44 of the heat-treating furnace of FIG. 4 in the step (ii) is transported in the solidification section 45 in the step (iii). During the transport, the molten silicon is gradually cooled from the melting temperature of silicon to the solidification temperature, at which it solidifies. The relationship between the temperature profile in the solidification section 45 and the transport speed by the roller conveyor is desirably set so that the molten silicon becomes monocrystaline in the cooling process.

When the substrate 22 with the silicon particles obtained by solidifying the molten silicon approaches the shutter 50 of the exit section 46, the shutter 51 is dosed and the valve 59 is opened. Then, the low oxidizing gas is supplied between the shutters 50 and 51 of the exit section 46 from the low oxidizing gas supply unit 56. As a result, the air therein is discharged from the exhaust pipe 63 and replaced with the low oxidizing gas. Thereafter, the shutter 50 is opened, and the substrate 22 is transported between the shutters 50 and 51. Upon completion of the transport, the shutter 50 is dosed to prevent the outside air from entering the heat-treating furnace 41, and the shutter 51 is opened. The substrate 22 is carried out of the exit section 46, and spherical silicon particles with a diameter of approximately 1 mm disposed on the substrate 22 are collected. When the molten silicon obtained in the melt section 44 is doped with boron, p-type silicon particles doped with boron can be obtained. By repeating the above procedure, silicon particles are continuously carried out of the furnace. During the process of transport inside the solidification section 45, the silicon is gradually cooled from the melting temperature thereof to the solidification temperature thereof.

In the above Example, boric acid is used as the p-type dopant source in the step (i), but it is also possible to use, for example, boron oxide instead. Boron oxide gradually decomposes to boric acid when dissolved in water and thus can produce essentially the same effect as boric acid.

Also, in order to produce n-type silicon particles, it is preferable to use, for example, phosphorus, a phosphorus compound, or triphenylphosphine oxide as the dopant source used in the step (i). It is practical to use phosphorus in powder form and triphenylphosphine oxide in the form of aqueous solution.

Further, it is also possible to produce p-type or n-type silicon particles by preparing a p-type or n-type silicon powder containing a high concentration of a dopant, mixing this powder with a dopant-free silicon powder at a predetermined rate to obtain a powder mixture, and producing granules by using the powder mixture as the feedstock.

The semiconductor particles obtained by the invention can be used as the bodies of spherical semiconductor elements for use in diodes, photosensors, or solar cells. The following describes representative spherical photovoltaic elements produced from silicon particles with a diameter of approximately 1.0 mm obtained in the above manner, and a photovoltaic device (low concentrator-type spherical solar cell) using such spherical photovoltaic elements.

### Application to solar cell

When spherical photovoltaic elements are produced from undoped silicon particles obtained in the step (iii), first, the silicon particles are provided with a p-type or n-type conductivity to obtain a spherical semiconductor. For example, when a p-type spherical semiconductor is produced, silicon particles are cleaned by etching the surface thereof, immersed in a boric acid aqueous solution, and dried to form a boric acid layer on the surface. The silicon particles are heated at a temperature slightly higher than the melting point of silicon in an inert gas atmosphere containing 5 to 20% by volume of oxygen to remelt the silicon particles, and then gradually cooled. As a result, the silicon particles are doped with boron to obtain p-type semiconductor particles. Also, due to the remelting and gradual cooling of the silicon particles, the silicon particles become more monocrystalline and their sphericity is heightened.

Next, the spherical p-type silicon particles obtained in the above manner or the p-type silicon particles obtained in the step (iii) are, for example, ground to heighten the sphericity and make their diameters to approximately 0.9 mm. Thereafter, a phosphorus diffusion layer (n-type semiconductor layer) is formed on the surfaces of the p-type silicon particles, to obtain spherical photovoltaic elements with a p-n junction. The diffusion layer is formed, for example, by spraying mist of POCl₃ solution on the surface of the spherical p-type semiconductor and applying a heat treatment of approximately 900°C thereto. Next, if necessary, a conductive antireflective coating, for example, a SnO₂ film with a thickness of 50 to 100 nm doped with fluorine or antimony is formed on the surface of each photovoltaic elements.

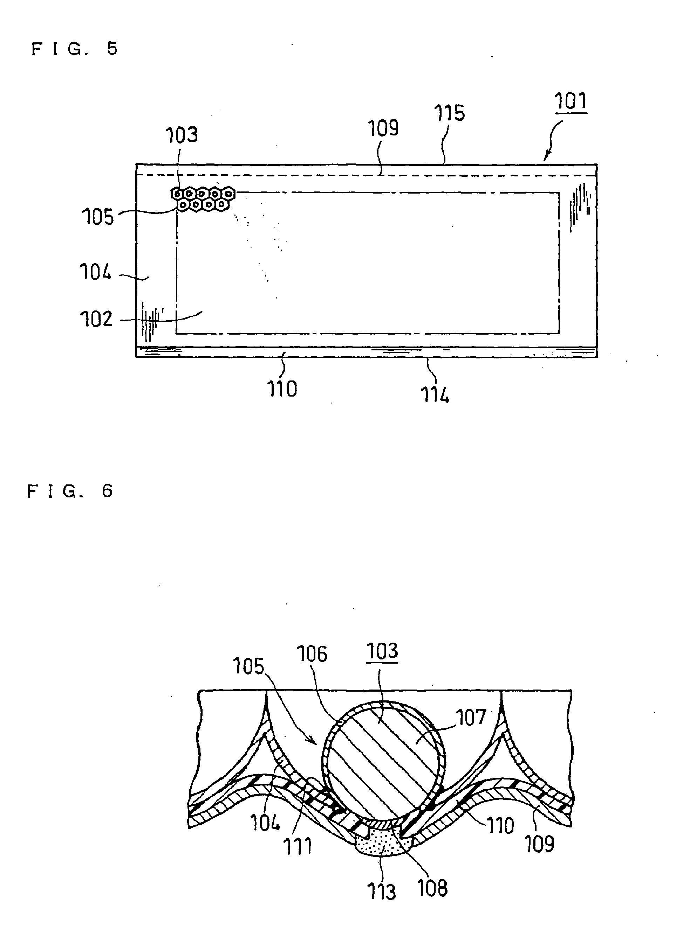

A photovoltaic device using these photovoltaic elements is described. FIG. 5 is a plan view of a power generation unit 101 of a photovoltaic device, and FIG 6 is a longitudinal sectional view of the main part of a power generation portion 102.

The power generation portion 102 is composed of: an aluminum substrate 104 with approximately 1800 recesses 105; and spherical photovoltaic elements (hereinafter referred to as elements) 103 of approximately 0.9 mm in diameter fixed to the recesses 105 one by one. Since light incident on the inner face of each recess 105 is reflected on the element 103, the photovoltaic conversion efficiency of the element 103 is heightened. The bottom of each recess 105 has an opening from which a part of the element 103 protrudes through the backside of the substrate 104. An n-type semiconductor layer 106 on the protruding part is selectively removed by etching or the like to expose the surface of a p-type silicon particle 107 serving as the body of the element 103. Formed on the exposed part is an electrode layer 108.

An electrically insulating layer 110 is bonded to the backside of the substrate 104. The electrically insulating layer 110 has a through-hole at a position facing the electrode layer 108. An aluminum conductive plate 109 is bonded to the backside of the electrically insulating layer 110. The conductive plate 109 has a through-hole at a position facing the through-hole of the electrically insulating layer 110. These through-holes communicate with each other. The peripheral edge of the opening of bottom of each recess 105 in the substrate 104 is electrically connected to the n-type semiconductor layer 106 of the element 103 by a connecting portion 111 made of a conductive adhesive. The surface of the n-type semiconductor layer 106 may be provided with such a conductive antireflective coating (not shown) as described above. A conductive paste 113 is filled into the communicating through-holes of the electrically insulating layer 110 and the conductive plate 109 so as to slightly overflow from the through-holes. The paste 113 electrically connects the electrode layer 108 directly under the p-type silicon particle 107 of the element 103 with the conductive plate 109.

One end of the substrate 104 serves as a terminal 115 of the power generation unit 101, while the end of the conductive plate 109 positioned on the backside of the other end of the substrate 104 serves as another terminal 114. Although this power generation unit has an output of approximately 1W, a plurality of power generation units may be electrically connected in series or in parallel by electric welding or the like, to produce a photovoltaic device capable of producing desired power with any voltage.
Although the present invention has been described in terms of the presently preferred embodiments, it is to be understood that such disclosure is not to be interpreted as limiting. Various alterations and modifications will no doubt become apparent to those skilled in the art to which the present invention pertains, after having read the above disclosure. Accordingly, it is intended that the appended claims be interpreted as covering all alterations and modifications as fall within the true spirit and scope of the invention.

## Claims

1. A method for producing semiconductor particles, comprising the steps of:
(i) forming granules of predetermined mass from a feedstock including a semiconductor powder by a granulation process;
(ii) heating the granules to melt and fuse the semiconductor powder included in the granules, to obtain molten spheres; and
(ii) cooling the molten spheres to solidify them, to obtain spherical semiconductor particles.

2. The method for producing semiconductor particles in accordance with daim 1, wherein the feedstock for forming the granules further includes a binder.

3. The method for producing semiconductor particles in accordance with claim 2, wherein the step (ii) further comprises a step of heating the granules to vaporize the binder by thermal decomposition, combustion, or evaporation.

4. The method for producing semiconductor particles in accordance with daim 2, wherein the step (ii) comprises the steps of:
(ii-1) preliminarily heating the granules at a temperature that is equal to or higher than a temperature at which the binder vaporizes by thermal decomposition, combustion, or evaporation and is lower than a temperature at which the semiconductor powder melts; and
(ii-2) heating the preliminarily heated granules at a temperature equal to or higher than the temperature at which the semiconductor powder melts.

5. The method for producing semiconductor particles in accordance with daim 4, wherein the step (ii-1) comprises a step of preliminarily heating the granules while forcefully discharging ambient gas.

6. The method for producing semiconductor particles in accordance with daim 4, wherein the semiconductor powder is a silicon powder, the heating temperature in the step (ii-1) is 500 to 1412°C, and the heating temperature in the step (ii-2) is 1413 to 1500°C.

7. The method for producing semiconductor particles in accordance with daim 4, wherein the step (ii-1) is performed in an atmosphere that is an inert gas or a substantially inert atmosphere composed mainly of an inert gas, and the step (ii-2) is performed in an atmosphere having a higher oxygen concentration than the atmosphere in the step (ii-1).

8. The method for producing semiconductor particles in accordance with daim 7, wherein the oxygen concentration in the atmosphere in the step (ii-1) is less than 1 % by volume, and the oxygen concentration in the atmosphere in the step (ii-2) is 5 to 20% by volume.

9. The method for producing semiconductor particles in accordance with claim 2, wherein the binder comprises at least one selected from the group consisting of polyvinyl alcohol, polyethylene glycol, hydroxylpropyl cellulose, paraffin wax, carboxymethyl cellulose, starch, and glucose.

10. The method for producing semiconductor particles in accordance with daim 2, wherein the step (i) comprises the steps of:
preparing the feedstock including the semiconductor powder;
pressing the feedstock into the shape of a sheet or noodle, and
cutting the pressed sheet or noodle to a predetermined shape and predetermined dimensions.

11. The method for producing semiconductor particles in accordance with daim 2,
wherein the step (i) uses a liquid binder and a granulating machine including a cylindrical frame, a rotatable disc disposed in the cylindrical frame, and an air slit between the disc and the cylindrical frame, and
the step (i) comprises a step of feeding the semiconductor powder to the disc, rotating the disc to move and roll the semiconductor powder, and spraying the liquid binder on the rolling semiconductor powder, to obtain granules.

12. The method for producing semiconductor particles in accordance with claim 2,
wherein in the step (i), the feedstock for forming the granules further includes a dopant source for making the conductivity of the semiconductor powder p-type or n-type, and
the step (ii) comprises a step of heating the granules to melt the semiconductor powder in the granules, to obtain molten spheres including p-type or n-type dopant.

13. The method for producing semiconductor particles in accordance with daim 12, wherein the binder is a liquid binder, and the dopant source is added to the liquid binder.

14. The method for producing semiconductor particles in accordance with daim 12, wherein the step (i) comprises the steps of:
bringing the semiconductor powder into contact with a solution containing the dopant source; and
forming granules containing the semiconductor powder in contact with the solution containing the dopant source by the granulation process.

15. The method for producing semiconductor particles in accordance with daim 12, wherein the step (i) comprises the steps of:
forming granules containing the semiconductor powder by the granulation process; and
bringing the granules into contact with a solution containing the dopant source.

16. The method for producing semiconductor particles in accordance with daim 12, wherein the semiconductor powder is a silicon powder, and the dopant source is a boron compound.

17. The method for producing semiconductor particles in accordance with claim 12, wherein the semiconductor powder is a silicon powder, and the dopant source is phosphorous or a phosphorous compound.

18. The method for producing semiconductor particles in accordance with claim 1,
wherein in the step (i), the feedstock for forming the granules further includes a dopant source for making the conductivity of the semiconductor powder p-type or n-type, and
the step (ii) comprises a step of heating the granules to melt the semiconductor powder in the granules, to obtain molten spheres including p-type or n-type dopant.

19. The method for producing semiconductor particles in accordance with claim 1, 2 or 18, wherein the semiconductor powder is a silicon powder, and the heating temperature for melting the semiconductor powder in the step (ii) is 1413 to 1500°C.

20. The method for producing semiconductor particles in accordance with claim 1 2 or 18, wherein the semiconductor powder has a mean particle diameter of 10 to 100 µm.
